# EUROPEAN PATENT APPLICATION

(11) **EP 4 761 554 A2**
(43) Date of publication of application: **17.06.2026**
(21) Application number: 25221560.3
(22) Date of filing: 08.12.2025
(51) Int. Cl.: H10N 69/00

(54) **QUANTUM DEVICE**

(30) Priority: 10.12.2024 JP 2024215424
(71) Applicant: FUJITSU LIMITED, Kawasaki-shi, Kanagawa 211-8588 (JP)
(72) Inventor: FUKUMORI, Taiga, Kawasaki-shi, 211-8588 (JP)
(74) Representative: Haseltine Lake Kempner LLP

(57) **Abstract**

A quantum device (1) includes a qubit substrate (170) having qubits and conductive pads coupled to the qubits, the qubit substrate (170) having a first thermal expansion coefficient; a first support (210) having a second thermal expansion coefficient; a plurality of second supports (220) disposed between the qubit substrate (170) and the first support (210), each having a third thermal expansion coefficient a plurality of coupling members (230) each coupling the first support (210) and a corresponding second support of the second supports (220); and spring pins (310) supported by the second supports and contacting the conductive pads. A control signal for controlling a state of each of the qubits is supplied to a corresponding conductive pad of the conductive pads through a corresponding spring pin of the spring pins (310). An absolute value of a difference between the first thermal expansion coefficient and the second thermal expansion coefficient is smaller than an absolute value of a difference between the first thermal expansion coefficient and the third thermal expansion coefficient.

## Description

### FIELD

The present disclosure relates to a quantum device.

### BACKGROUND

A quantum device has been proposed in which, when controlling the state of qubits provided on a qubit chip, spring pins are brought into contact with conductive pads coupled to the qubits so that control signals are supplied to the qubits through the spring pins. The spring pins are supported by a metallic housing.

### Related Art Documents

### [Patent Documents]

[Patent Document 1] International Publication Pamphlet No. WO 2023/188391
[Patent Document 2] U.S. Patent No. 10756004
[Patent Document 3] Japanese Laid-Open Patent Application No. 2007-093320
[Patent Document 4] Japanese Laid-Open Patent Application No. 2020-061554

### [Non-Patent Document]

[Non-Patent Document 1] "Basic knowledge for understanding research on quantum computers using superconducting circuits," Tsuyoshi Yamamoto, Journal of the Physical Society of Japan, Vol. 75, No. 10, 2020.

The quantum device is used, for example, at cryogenic temperatures of several tens of millikelvins (mK). When the quantum device is cooled from room temperature to cryogenic temperatures, the metallic housing contracts more than the qubit chip. As a result, even if the spring pins are in contact with the conductive pads at room temperature, at cryogenic temperatures the spring pins may become detached from the conductive pads, and the contact between the spring pins and the conductive pads may not be maintained.

### SUMMARY

Accordingly, it is an object in one aspect of the embodiments to provide a quantum device that suppresses contact failures between the spring pins and the conductive pads caused by temperature changes.

According to one aspect of the present disclosure, a quantum device is provided. The quantum device includes:
a qubit substrate having qubits and conductive pads coupled to the qubits, the qubit substrate having a first thermal expansion coefficient;
a first support having a second thermal expansion coefficient;
a plurality of second supports disposed between the qubit substrate and the first support, each of the second supports having a third thermal expansion coefficient;
a plurality of coupling members, each coupling the first support and a corresponding second support of the second supports; and
spring pins supported by the second supports and in contact with the conductive pads,
wherein a control signal for controlling a state of each of the qubits is supplied to a corresponding conductive pad of the conductive pads through a corresponding spring pin of the spring pins, and
wherein an absolute value of a difference between the first thermal expansion coefficient and the second thermal expansion coefficient is smaller than an absolute value of a difference between the first thermal expansion coefficient and the third thermal expansion coefficient.

### ADVANTAGEOUS EFFECT OF THE INVENTION

According to the present disclosure, contact failures between the spring pins and the conductive pads due to temperature changes can be reduced.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 is a cross-sectional view illustrating a quantum device according to a first embodiment;
FIG. 2 is a plan view illustrating an arrangement of a qubit chip, a first support, and second supports in a quantum device according to a first embodiment;
FIG. 3 is a schematic view of a qubit chip;
FIG. 4 is a cross-sectional view illustrating a quantum device according to a second embodiment;
FIG. 5 is a plan view illustrating an arrangement of a qubit chip, a first support, and second supports in a quantum device according to a second embodiment;
FIG. 6 is a cross-sectional view illustrating a quantum device according to a third embodiment;
FIG. 7 is a plan view illustrating an arrangement of a qubit chip, a first support, and second supports in a quantum device according to a third embodiment;
FIG. 8 is a cross-sectional view illustrating a quantum device according to a fourth embodiment;
FIG. 9 is a cross-sectional view illustrating a rotation restricting member;
FIG. 10 is a cross-sectional view illustrating a quantum device according to a fifth embodiment;
FIG. 11 is a cross-sectional view illustrating a quantum device according to a sixth embodiment;
FIG. 12 is a cross-sectional view illustrating a quantum device according to a seventh embodiment; and
FIG. 13 is a cross-sectional view illustrating a quantum device according to an eighth embodiment.

### DESCRIPTION OF EMBODIMENTS

In the following, embodiments of the present disclosure will be described in detail with reference to the accompanying drawings. In the present specification and drawings, components having substantially the same functional configuration may be denoted by the same reference numerals, and redundant description may be omitted. In the present disclosure, the thermal expansion coefficient refers to a value at 293 K, and the thermal contraction rate refers to thermal contraction amount per unit length.

### (First Embodiment)

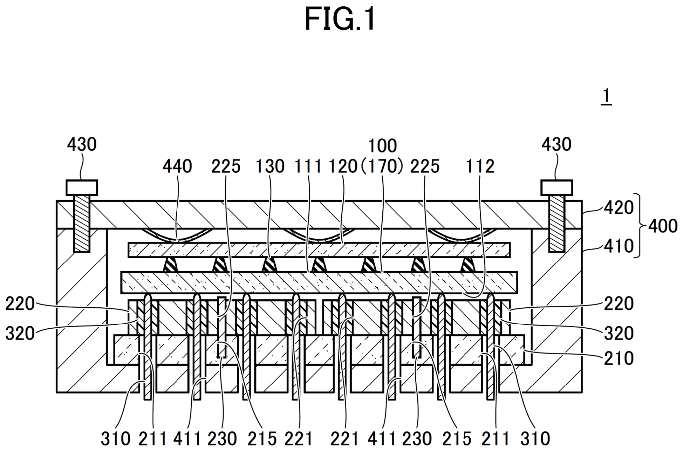

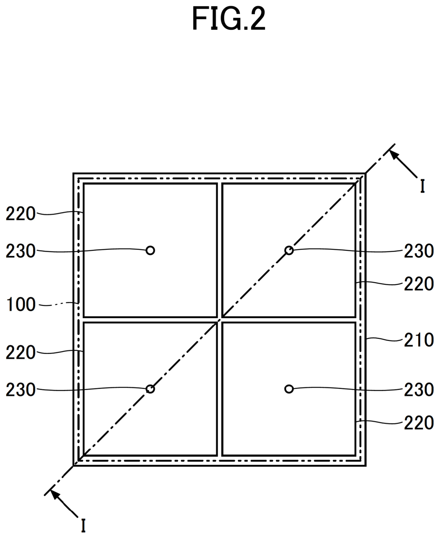

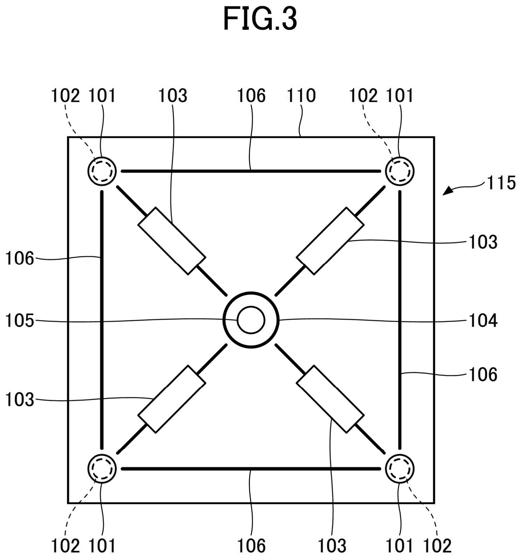

A first embodiment will be described. The first embodiment relates to a quantum device. FIG. 1 is a cross-sectional view illustrating a quantum device according to the first embodiment. FIG. 2 is a plan view illustrating an arrangement of a qubit chip, a first support, and second supports in the quantum device according to the first embodiment. FIG. 1 corresponds to a cross-sectional view taken along line I-I in FIG. 2. FIG. 3 illustrates an outline of the qubit chip.

As illustrated in FIGS. 1 and 2, a quantum device 1 according to a first embodiment includes a qubit substrate 170, a first support 210, a plurality of second supports 220, a plurality of coupling members 230, spring pins 310, and a housing 400.

The housing 400 includes a container 410 and a lid 420. The container 410 accommodates the qubit substrate 170, the first support 210, the plurality of second supports 220, and the plurality of coupling members 230. The lid 420 is fixed to the container 410 by, for example, screws 430. The housing has a fourth thermal expansion coefficient α₄. The container 410 and the lid 420 are metallic and are mainly made of, for example, aluminum or copper. The thermal expansion coefficient of aluminum is 24×10⁻⁶ K⁻¹, and the thermal expansion coefficient of copper is 17×10⁻⁶ K⁻¹. The fourth thermal expansion coefficient α₄ is, for example, equal to or greater than 17×10⁻⁶ K⁻¹ and equal to or less than 24×10⁻⁶ K⁻¹.

The thermal contraction of aluminum and copper when the temperature changes from room temperature to 0 K is 0.4% and 0.3%, respectively. The thermal contraction of the housing 400 when the temperature changes from room temperature to 0 K is, for example, equal to or greater than 0.3% and equal to or less than 0.4%.

The qubit substrate 170 has a qubit chip 100. As illustrated in FIG. 3, the qubit chip 100 has a substrate 110. As illustrated in FIG. 1, the substrate 110 has a first main surface 111, and a second main surface 112 on the opposite side from the first main surface 111. In this specification, the direction in which the first main surface 111 is located as viewed from the second main surface 112 is referred to as the upper side, and the direction in which the second main surface 112 is located as viewed from the first main surface 111 is referred to as the lower side. Further, the plan view refers to viewing from above, and the plan shape refers to the shape of the object viewed from above. As illustrated in FIG. 2, the qubit chip 100 has a square plan shape. For example, in plan view, the length of one side of the qubit chip 100 is equal to or greater than 40 mm and equal to or less than 50 mm.

As illustrated in FIG. 3, the qubit chip 100 has an input/output unit 115. The input/output unit 115 has, for example, four qubits 101, four conductive pads 102, four resonators 103, one filter 104, one input/output port 105, and four inter-qubit interconnects 106. For example, the qubits 101, the resonators 103, the filter 104, and the inter-qubit interconnects 106 are disposed on the first main surface 111, the conductive pads 102 are disposed on the second main surface 112, and the input/output port 105 has a portion provided on the first main surface 111 and a portion provided on the second main surface 112.

In a plan view, four qubits 101 are arranged at the vertices of a square, and an input/output port 105 is arranged at the center of the square. A resonator 103 is arranged between the corresponding qubit 101 and the input/output port 105. The resonators 103 are respectively coupled to the qubits 101. A filter 104 is arranged between the resonator 103 and the input/output port 105, and is coupled to the resonator 103 and the input/output port 105. The resonator 103 is coupled to the input/output port 105 via the filter 104. An inter-qubit interconnect 106 is arranged between two qubits 101, and is coupled to the two qubits 101. Four conductive pads 102 are each arranged at positions overlapping with the qubits 101 in a plan view, and are coupled to the qubits 101. The qubit chip 100 may have two or more input/output units 115.

The substrate 110 is, for example, a single-crystal silicon substrate or a sapphire substrate, and the qubit chip 100 has a first thermal expansion coefficient α₁. The thermal expansion coefficient of single-crystal silicon is 2.32×10⁻⁶ K⁻¹, and the thermal expansion coefficient of sapphire is 6.4×10⁻⁶ K⁻¹. The substrate 110 may be a quartz substrate or a diamond substrate. The thermal expansion coefficient of quartz is 7.5×10⁻⁶ K⁻¹, and the thermal expansion coefficient of diamond is 1×10⁻⁶ K⁻¹. Since the volume of the qubits 101, the conductive pads 102, the resonators 103, the filter 104, the input/output port 105, and the inter-qubit interconnects 106 is negligibly small compared with the volume of the substrate 110, the first thermal expansion coefficient α₁ may be approximated by the thermal expansion coefficient of the substrate 110. The first thermal expansion coefficient α₁ is, for example, equal to or greater than 1×10⁻⁶ K⁻¹ and equal to or less than 7.5×10⁻⁶ K⁻¹.

The thermal contraction of single-crystal silicon, sapphire, quartz, and diamond when the temperature changes from room temperature to 0 K is 0.02%, 0.08%, 0.1%, and 0.02%, respectively. The thermal contraction of the qubit chip 100 when the temperature changes from room temperature to 0 K is, for example, equal to or greater than 0.02% and equal to or less than 0.1%.

The first support 210 is disposed on the bottom of the container 410. For example, the first support 210 contacts the bottom of the container 410. The first support 210 has a plate-like shape. As illustrated in FIG. 2, the first support 210 has a square planar shape. In plan view, the first support 210 may protrude from the qubit chip 100. The first support 210 is, for example, a single-crystal silicon plate, a sapphire plate, or a ceramic plate, and has a second thermal expansion coefficient α₂. Examples of the ceramics include alumina, aluminum nitride, and low-temperature co-fired ceramics (LTCC). The thermal expansion coefficient of the ceramics is, for example, equal to or greater than 3×10⁻⁶ K⁻¹ and equal to or less than 8×10⁻⁶ K⁻¹. The first support 210 may be a quartz plate or a diamond plate. The second thermal expansion coefficient α₂ is, for example, equal to or greater than 1×10⁻⁶ K⁻¹ and equal to or less than 8×10⁻⁶ K⁻¹. The second thermal expansion coefficient α₂ is preferably equal to the first thermal expansion coefficient α₁, but may be different.

The thermal contraction of the ceramics when the temperature changes from room temperature to 0 K is, for example, equal to or greater than 0.05% and equal to or less than 0.1%. The thermal contraction of the first support 210 when the temperature changes from room temperature to 0 K is, for example, equal to or greater than 0.02% and equal to or less than 0.1%.

A plurality of second supports 220, here four second supports 220, are arranged on the first support 210. For example, the second supports 220 are in contact with the upper surface of the first support 210. Each of the second supports 220 is disposed between the qubit chip 100 and the first support 210. The second supports 220 have a planar shape. As illustrated in FIG. 2, the second supports 220 have a square planar shape. In plan view, the four second supports 220 are arranged to form a matrix of two rows and two columns. In plan view, the sides of the qubit chip 100, the first support 210, and the second supports 220 are parallel or perpendicular to each other. For example, in plan view, the side length of the second supports 220 is equal to or greater than 20 mm and equal to or less than 25 mm. The second support 220 is, for example, a metal plate and has a third thermal expansion coefficient α₃. Examples of the metal plate include an aluminum plate and a copper plate. The third thermal expansion coefficient α₃ is, for example, equal to or greater than 17×10⁻⁶ K⁻¹ and equal to or less than 24×10⁻⁶ K⁻¹.

The thermal contraction of the second support 220 when the temperature is changed from room temperature to 0 K is, for example, equal to or greater than 0.3% and equal to or less than 0.4%.

The plurality of coupling members 230, here four coupling members 230, couple the first support 210 and the respective second supports 220. That is, each of the four second supports 220 is coupled to the first support 210 by one coupling member 230. For example, four holes 215 are formed on the upper surface of the first support 210, holes 225 passing through the second supports 220 are formed in the respective second supports 220, and location pins as coupling members 230 are fitted into the holes 215 and 225. The coupling member 230 has a cylindrical shape. For example, the diameter of the coupling member 230 is approximately 1 mm. The material of the coupling member 230 is the same as that of the second support 220. The coupling member 230 and the second support 220 may be integrally formed.

A plurality of holes 221 penetrating the second support 220 are formed in each of the second supports 220, a plurality of holes 211 penetrating the first support 210 are formed in the first support 210, and a plurality of holes 411 penetrating the bottom plate of the container 410 are formed in the bottom plate of the container 410. The holes 221, 211, and 411 are linearly coupled to each other. Spring pins 310 are disposed in the holes 221, 211, and 411, respectively. Diameters of the holes 221 and 211 are larger than the diameters of the spring pins 310 in plan view. Dielectric members 320 are disposed between the spring pins 310 and wall surfaces of the holes 221. The dielectric members 320 are made of, for example, organic resin. The spring pins 310 are supported by the second supports 220 through the dielectric members 320. There is a gap between the spring pin 310 and the wall surface of the hole 211. There may be a gap between the spring pin 310 and the wall surface of the hole 411, or the spring pin 310 may be in close contact with the wall surface of the hole 411. The spring pins 310 are in contact with the conductive pad 102. A control signal for controlling a state of the qubit 101 is supplied to the conductive pad 102 through the spring pin 310. The control signal is, for example, a radio frequency (RF) signal having a frequency of equal to or greater than 2 GHz and equal to or less than 10 GHz. The spring pins 310 are metallic and are mainly made of, for example, copper.

The qubit chip 100 further includes a cover chip 120, a plurality of bonding members 130, and a plurality of elastic pressing members 440.

The cover chip 120 is disposed between the qubit chip 100 and the lid 420. The bonding members 130 are disposed between the qubit chip 100 and the cover chip 120. The bonding members 130 bonds the qubit chip 100 and the cover chip 120. The elastic pressing members 440 are disposed between the cover chip 120 and the lid 420, and contact the cover chip 120 and the lid 420. The elastic pressing members 440 are, for example, a leaf spring and are supported by the lid 420 to press the cover chip 120 toward the bottom plate of the container 410. The spring pins 310 also press the qubit chip 100 toward the lid 420. The bonding members 130 may have conductivity, and the cover chip 120 may have interconnects or the like coupled to the qubit chip 100.

The absolute value Δα₂1 (|α₂ - α₁|) of the difference between the first thermal expansion coefficient α₁ and the second thermal expansion coefficient α₂ is smaller than the absolute value Δα₃1 (|α₃ - α₁|) of the difference between the first thermal expansion coefficient α₁ and the third thermal expansion coefficient α₃. The absolute value Δα₂1 is also smaller than the absolute value Δα₄1 (|α₄ - α₁|) of the difference between the first thermal expansion coefficient α₁ and the fourth thermal expansion coefficient α₄.

In the quantum device 1, the spring pins 310 are supported by four second supports 220. Therefore, compared with a case where all the spring pins 310 are supported by one object, for example, one container 410, the movement amount of the spring pins 310 accompanying thermal contraction when the quantum device 1 is cooled from room temperature to cryogenic temperatures can be reduced. Therefore, contact between the spring pins 310 and the conductive pads 102 can be easily maintained, and defective contact between the spring pins 310 and the conductive pads 102 due to temperature change can be reduced.

Since the second supports 220 are metallic, the holes 221 into which the spring pins 310 and the dielectric members 320 are inserted can be formed by machining with high accuracy. Furthermore, since the second supports 220 are metallic, high thermal conductivity can be obtained, the temperature difference between the housing 400 and the qubit chip 100 can be easily reduced, and the qubit chip 100 can be easily cooled in a short time in a case of the housing 400 being cooled. Furthermore, the difference in thermal contraction between the metallic spring pins 310 can be reduced, and the second supports 220 can continue to support the spring pins 310 even when thermal contraction occurs. Furthermore, since the second supports 220 are metallic, the effect of electromagnetic waves from the outside on the qubit chip 100 can be reduced by the second supports 220. A ground potential may be applied to the qubit chip 100 via the second supports 220.

However, when the second supports 220 are metallic, the difference in thermal contraction between the qubit chip 100 and the second supports 220 tends to be large. With respect to the above, the quantum device 1 includes a first support 210 having a small difference in thermal contraction with the qubit chip 100, and the coupling members 230 couple the first support 210 and the second supports 220. That is, an absolute value Δα₂1 is smaller than an absolute value Δα₃1. Accordingly, the relative positional shift between the qubit chip 100 and the first support 210 is small, and even when the second supports 220 coupled to the first support 210 via the coupling members 230 contract more than the first support 210 due to thermal contraction, the amount of displacement of the spring pins 310 due to thermal contraction can be reduced. Therefore, even when the second supports 220 are metallic, it becomes easier to maintain contact between the spring pins 310 and the conductive pads 102, and contact failures between the spring pins 310 and the conductive pads 102 due to temperature changes can be reduced.

In addition, because the housing 400 is metallic, the effect of electromagnetic waves from outside on the qubit chip 100 can be reduced. Although the difference in thermal contraction between the qubit chip 100 and the metallic housing 400 tends to be large, in the quantum device 1, since the spring pins 310 are not supported by the housing 400, no movement of the spring pins 310 occurs due to the thermal contraction of the housing 400.

In the quantum device 1, the qubit chip 100 and the cover chip 120 are elastically held in the vertical direction by the spring pins 310 and the elastic pressing members 440. Accordingly, the positions of the qubit chip 100 and the cover chip 120 are stabilized. In addition, the strokes of the spring pins 310 can be increased to accommodate dimensional errors or to prevent breakage.

The elastic pressing members 440 may directly contact the qubit chip 100; however, by providing the cover chip 120, effects and mechanical damage to circuits provided on the qubit chip 100 caused by the elastic pressing members 440 can be avoided. In addition, when a groove is formed in the cover chip 120 so as not to contact the circuits on the qubit chip 100, the cover chip 120 may be disposed on the qubit chip 100 without providing the bonding members 130.

The absolute value Δα₂1 is preferably 5×10⁻⁶ K⁻¹ or less, more preferably 3×10⁻⁶ K⁻¹ or less, and more preferably 1×10⁻⁶ K⁻¹ or less. The absolute value Δα₂1 is preferably 1/10 or less of the absolute value Δα₃1. The smaller the absolute value Δα₂1, the smaller the relative positional deviation between the qubit chip 100 and the first support 210 caused by cooling, the easier the contact between the spring pins 310 and the conductive pads 102 is maintained, and defective contact between the spring pins 310 and the conductive pads 102 due to a temperature change can be reduced.

The difference between the thermal contraction of the qubit chip 100 and the thermal contraction of the first support 210 when the temperature changes from room temperature to 0 K is preferably 0.1% or less, and more preferably 0.05% or less. The smaller the difference, the smaller the relative positional shift between the qubit chip 100 and the first support 210 caused by cooling, the easier the contact between the spring pins 310 and the conductive pads 102 can be maintained, and defective contact between the spring pins 310 and the conductive pads 102 caused by the temperature change can be reduced.

### (Second Embodiment)

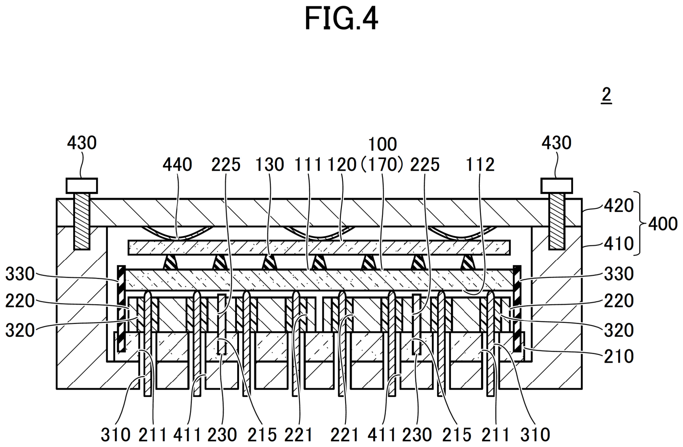

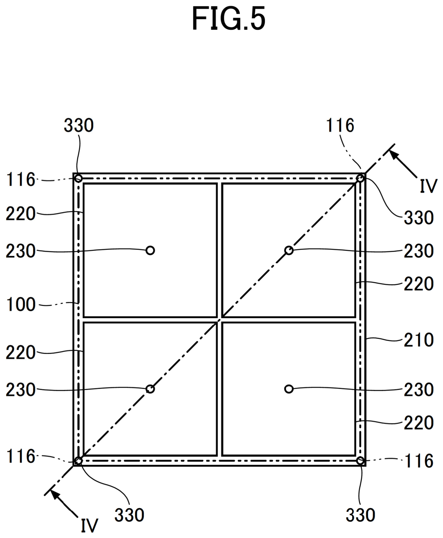

A second embodiment will be described. The second embodiment mainly differs from the first embodiment in that the second embodiment includes constraining members. FIG. 4 is a cross-sectional view illustrating a quantum device according to the second embodiment. FIG. 5 is a plan view illustrating the arrangement of the qubit chip, the first support, and the second supports in the quantum device according to the second embodiment. FIG. 4 corresponds to a cross-sectional view along line IV-IV in FIG. 5.

As illustrated in FIGS. 4 and 5, a quantum device 2 according to the second embodiment includes a plurality of constraining members 330. In plan view, recesses 116 that are inwardly recessed are formed at the four corners of the qubit chip 100, and the constraining members 330 are disposed at positions overlapping the recesses 116 in plan view of the first support 210. The constraining members 330 may contact the qubit chip 100. Each constraining member 330 has, for example, a cylindrical shape. The constraining members 330 are configured to constrain the qubit chip 100 relative to the first support 210 in a direction parallel to the first main surface 111. Materials for the constraining members 330 may be similar to those for the second supports 220.

Other configurations of the quantum device 2 are the same as those of the quantum device 1. The quantum device 2 can achieve the same effects as the quantum device 1. In addition, in the quantum device 2, since the constraining members 330 are disposed, the relative positional shift between the first support 210 and the qubit chip 100 can be reduced. When the quantum device 2 is cooled, the constraining members 330 move along with the thermal contraction of the first support 210; however, since the qubit chip 100 also thermally contracts to a similar extent as the first support 210, the constraining members 330 can continue to constrain the qubit chip 100 relative to the first support 210. Furthermore, during assembly of the quantum device 2, the constraining members 330 can be used as guides to position the qubit chip 100.

### (Third Embodiment)

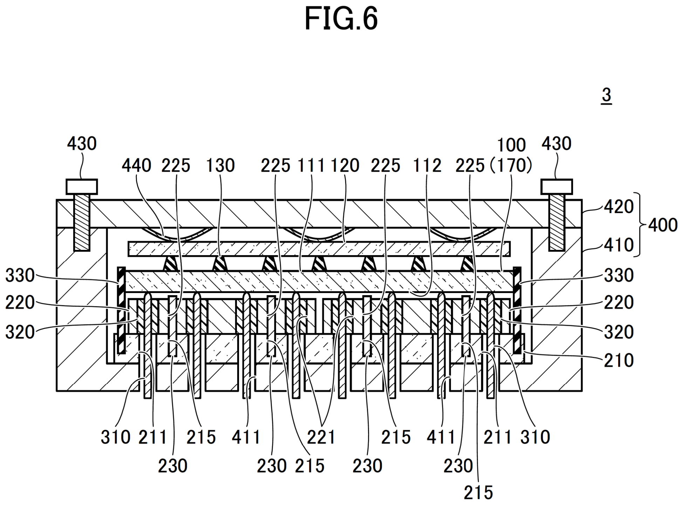

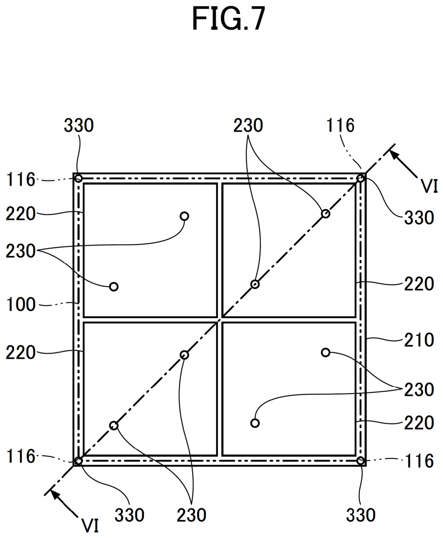

A third embodiment will be described. The third embodiment differs from the second embodiment mainly in that each of the plurality of second supports is coupled to the first support by a plurality of coupling members. FIG. 6 is a cross-sectional view illustrating a quantum device according to the third embodiment. FIG. 7 is a plan view illustrating the arrangement of the qubit chip, the first support, and the second supports in the quantum device according to the third embodiment. FIG. 6 corresponds to a cross-sectional view taken along line VI-VI in FIG. 7.

As illustrated in FIGS. 6 and 7, in a quantum device 3 according to the third embodiment, each of the four second supports 220 is coupled to the first support 210 by a plurality of coupling members 230, here two coupling members 230. That is, two coupling members 230 are disposed with respect to one second support 220.

Other configurations of the quantum device 3 are the same as those of the quantum device 2. The quantum device 3 can achieve the same effects as the quantum device 2. In addition, in the quantum device 3, since each of the four second supports 220 is coupled to the first support 210 by two coupling members 230, rotation of the second supports 220 in a plane parallel to the first main surface 111 around the coupling members 230 as a rotation center is less likely to occur. Therefore, the contact between the spring pins 310 and the conductive pads 102 can be more reliably maintained, and contact failures between the spring pins 310 and the conductive pads 102 due to temperature changes can be reduced.

It is preferable that, at room temperature, a gap exists between the coupling members 230 and the wall surfaces of the holes 225 that is larger than the amount of movement of the holes 225 due to thermal contraction of the second supports 220 when cooled to cryogenic temperatures. For example, when it is assumed that the second supports 220 will thermally contract by 50 µm along the diagonal in plan view, it is preferable that a gap of 25 µm or more exists between each coupling member 230 and the wall surface of the corresponding hole 225.

### (Fourth Embodiment)

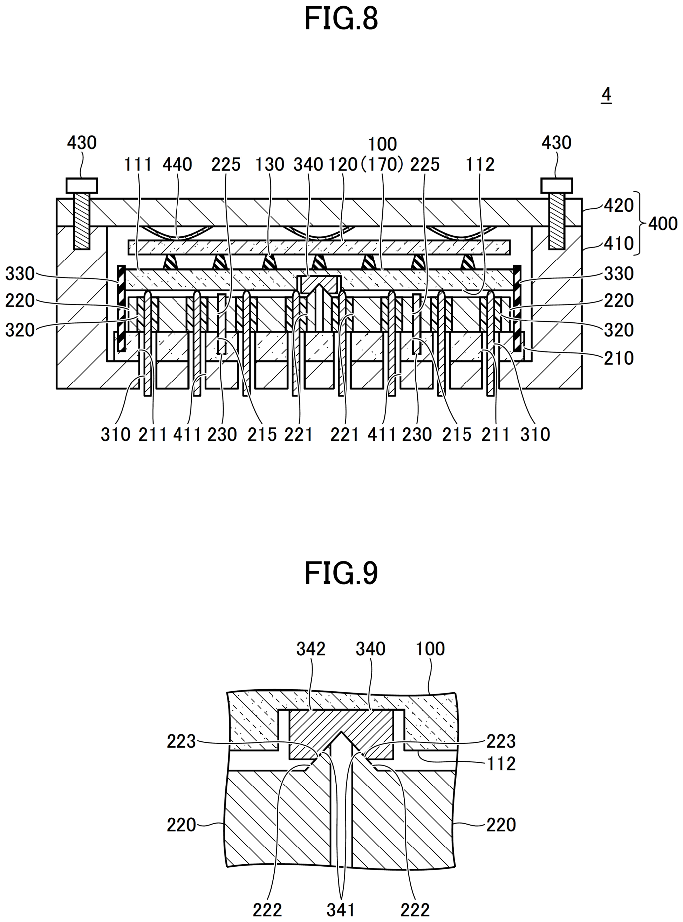

A fourth embodiment will be described. The fourth embodiment differs from the second embodiment mainly in that the fourth embodiment includes a rotation restricting member. FIG. 8 is a cross-sectional view of a quantum device according to the fourth embodiment. FIG. 9 is a cross-sectional view illustrating the rotation restricting member.

As illustrated in FIGS. 8 and 9, in a quantum device 4 according to the fourth embodiment, each of the second supports 220 has a protrusion 222 extending toward the qubit chip 100 (qubit substrate 170). The protrusions 222 are, for example, formed in the vicinity of the adjacent second supports 220. The protrusions have inclined surfaces 223 that are inclined toward the qubit chip 100 as the protrusions extend away from the respective coupling members 230. The inclined surfaces 223 become closer to the adjacent second supports 220 as they extend upward.

The quantum device 4 includes a rotation restricting member 340. The rotation restricting member 340 has two first surfaces 341 in contact with the inclined surfaces 223 of two adjacent second supports 220, and a second surface 342 in contact with the qubit chip 100 (qubit substrate 170).

Other configurations of the quantum device 4 are similar to those of the quantum device 2. The quantum device 4 can achieve the same effects as the quantum device 2. In the quantum device 4, when the quantum device 4 is placed under cryogenic temperatures and the second supports 220 contracts toward the coupling member 230, a force acts to move the rotation restricting member 340 upward. At the same time, since the second surface 342 contacts the qubit chip 100, a mutual pressing force acts between the first surfaces 341 and the inclined surfaces 223. As a result, it becomes less likely that the second supports 220 rotate in a plane parallel to the first main surface 111 with the respective coupling members 230 serving as a center of rotation.

It should be noted that, at the operating temperature of the quantum device 4, for example, under cryogenic temperatures, when the second surface 342 contacts the qubit chip 100, the second surface 342 need not contact the qubit chip 100 at room temperature.

### (Fifth Embodiment)

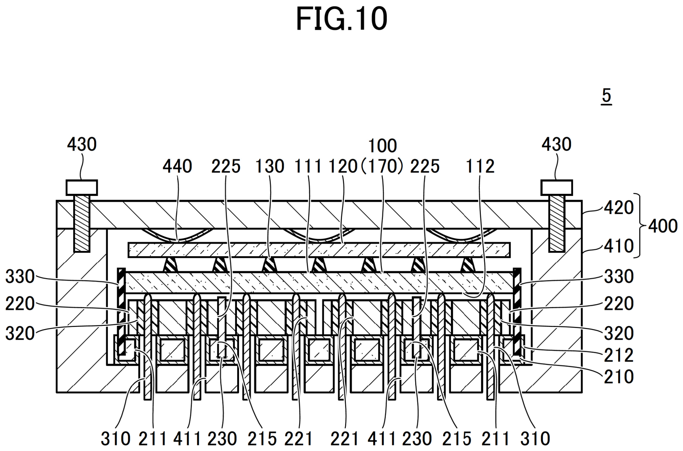

A fifth embodiment will be described. The fifth embodiment mainly differs from the second embodiment in that the fifth embodiment includes a metal layer covering the first support. FIG. 10 is a cross-sectional view illustrating a quantum device according to the fifth embodiment.

As illustrated in FIG. 10, a quantum device 5 according to the fifth embodiment has a metal layer 212 that covers the first support 210. The metal layer 212 contacts the first support 210. For example, the metal layer 212 covers the upper, lower, and side surfaces of the first support 210, as well as the wall surfaces of the holes 211. The metal layer 212 contacts the second supports 220 and the container 410 of the housing 400. The metal layer 212 is mainly made of, for example, copper.

Other configurations of the quantum device 5 are the same as those of the quantum device 2. The quantum device 5 can also provide the same effects as the quantum device 2. In addition, in the quantum device 5, since the first support 210 is covered with the metal layer 212, and the metal layer 212 contacts the second supports 220 and the container 410, the first support 210 can be cooled more easily than in the quantum device 2. Accordingly, the time required to cool the entire quantum device 5 to an ultralow temperature can be shortened compared with the time required to cool the entire quantum device 2 to an ultralow temperature. For example, the cooling time can be reduced to approximately 1/10 to 1/100.

### (Sixth Embodiment)

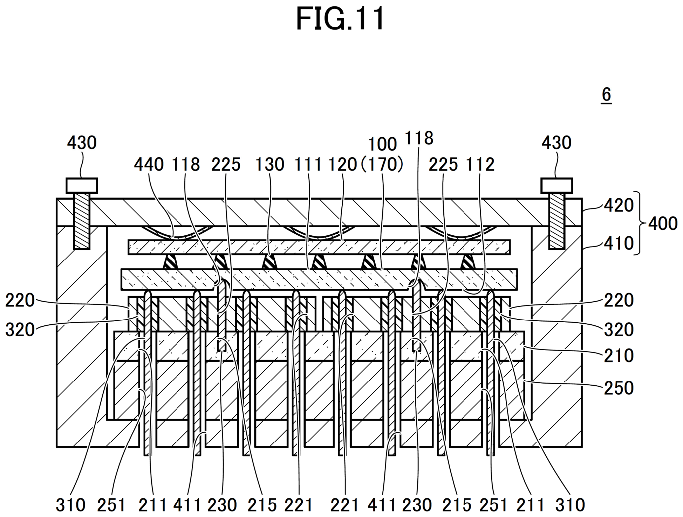

A sixth embodiment will be described. The sixth embodiment mainly differs from the first embodiment in that the sixth embodiment includes a spacer. FIG. 11 is a cross-sectional view illustrating a quantum device according to the sixth embodiment.

As illustrated in FIG. 11, a quantum device 6 according to the sixth embodiment has a spacer 250 disposed between the housing 400 and the first support 210. For example, the spacer 250 is arranged on the bottom plate of the container 410 and contacts the bottom surface of the container 410. Holes 251 passing through the spacer 250 are formed in the spacer 250. The holes 251 are coupled to the holes 211 and the holes 411, respectively, and spring pins 310 are also provided in the holes 251, respectively. In plan view, the diameter of the hole 251 is larger than the diameter of the spring pin 310. There is a gap between the spring pin 310 and the wall surface of the hole 251. Examples of the material of the spacer 250 include the same material as that of the first support 210 and the same material as that of the second support 220.

Further, the qubit chip 100 includes a recess 118 into which a tip of a corresponding coupling member of the coupling members 230 is inserted. The recesses 118 are formed on the second main surface 112 facing the second support 220 of the qubit chip 100.

Other configurations of the quantum device 6 are the same as those of the quantum device 1. The same effect as that of the quantum device 1 can be obtained by the quantum device 6. Further, in the quantum device 6, a spacer 250 is disposed between the first support 210 and the bottom plate of the container 410, and the tips of the coupling members 230 are inserted into the recesses 118. Therefore, even when the spring pins 310 can move with thermal contraction of the housing 400, the amount of movement is small.

The spacer 250 may be provided for each of the second supports 220. For example, four spacers 250 may be provided, one beneath each of the second supports 220. The same applies to the following embodiments.

### (Seventh Embodiment)

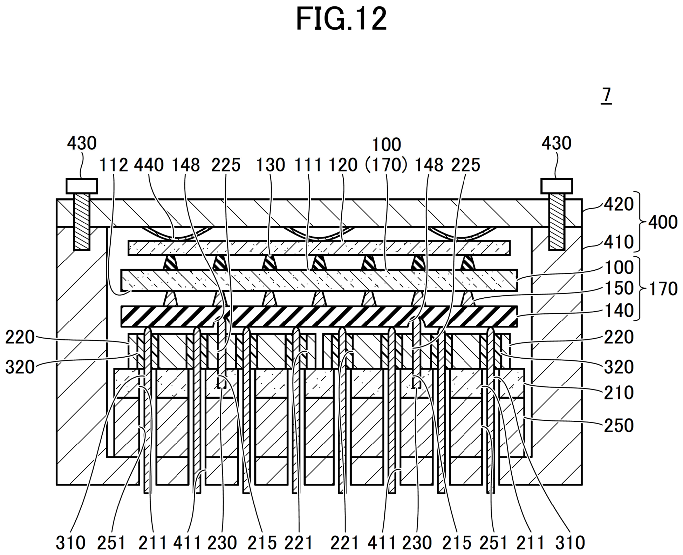

A seventh embodiment will be described. The seventh embodiment differs from the sixth embodiment mainly in that the qubit substrate has an interposer. FIG. 12 is a cross-sectional view illustrating a quantum device according to the seventh embodiment.

As illustrated in FIG. 12, in a quantum device 7 according to the seventh embodiment, the qubit substrate 170 has an interposer 140 and a plurality of conductive bonding members 150 in addition to the qubit chip 100. The interposer 140 is disposed between the qubit chip 100 and the second supports 220. The conductive bonding members 150 are disposed between the qubit chip 100 and the interposer 140, and bond the qubit chip 100 and the interposer 140 to each other. The interposer 140 is fixed to the qubit chip 100 and electrically coupled to the qubit chip 100 through the conductive bonding members 150. In the quantum device 7, the interposer 140 has a conductive pad (not illustrated) with which the spring pin 310 is in contact, and this conductive pad is electrically coupled to the conductive pad 102 through the conductive bonding members 150. The interposer 140 has the same thermal expansion coefficient as the qubit chip 100, and also in this embodiment, the qubit substrate 170 has the first thermal expansion coefficient α₁.

Further, the recess 118 is not formed in the qubit chip 100, and a recess 148 into which a tip of the corresponding one of the coupling members 230 is inserted is formed in the interposer 140. The recesses 148 are formed on the main surface of the interposer 140 facing the second support 220.

Other configurations of the quantum device 7 are the same as those of the quantum device 6. The quantum device 7 can also achieve the same effects as the quantum device 6. Further, in the quantum device 7, since the qubit substrate 170 includes the interposer 140, the qubit substrate 170 can more easily incorporate complex circuits.

The quantum devices 1, 2, 3, 4 or 5 may have an interposer similar to the interposer 140.

### (Eighth Embodiment)

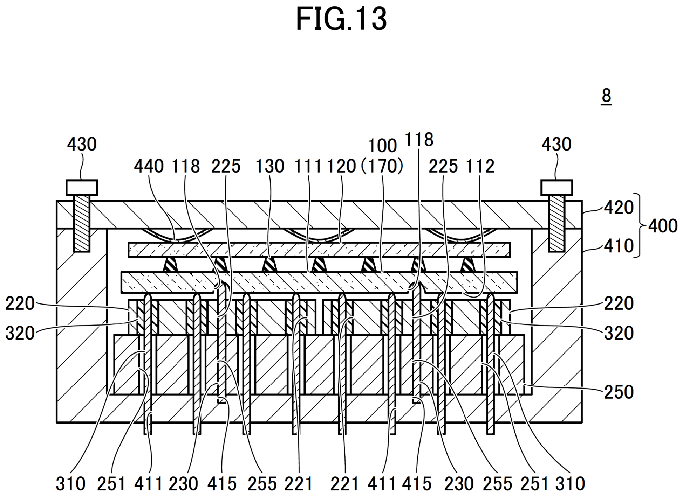

An eighth embodiment will be described. The eighth embodiment differs from the sixth embodiment mainly in that the coupling members couple the housing and the second supports. FIG. 13 is a cross-sectional view illustrating a quantum device according to an eighth embodiment.

As illustrated in FIG. 13, a quantum device 8 according to the eighth embodiment does not include the first support 210, and the coupling members 230 are supported by the container 410 of the housing 400. The plurality of coupling members 230, here four coupling members 230, couple the housing 400 and the respective second supports 220. In other words, each of the four second supports 220 is coupled to the housing 400 by a corresponding coupling member of the coupling members 230. For example, four holes 415 are formed in the upper surface of the bottom plate of the container 410, holes 255 penetrating the spacer 250 are formed in the spacer 250, and the coupling members 230 are fitted into the holes 415, 255, and 225, respectively.

Other configurations of the quantum device 8 are the same as those of the quantum device 6.

Also in the quantum device 8, the spring pins 310 are supported by the four second supports 220. Accordingly, as in the quantum device 1, it is easier to maintain the contact between the spring pins 310 and the conductive pads 102, and to restrict contact failure between the spring pins 310 and the conductive pads 102 due to temperature changes. In addition, as in the first embodiment, the effects of the second supports 220 being made of metal can be obtained.

Furthermore, since the spacer 250 is disposed between the second supports 220 and the bottom plate of the container 410, and the tips of the coupling members 230 are inserted into the recesses 118, although the coupling members 230 are slightly inclined due to thermal contraction of the metal housing 400 supporting the coupling members 230, the positional shift between the qubit chip 100 and the coupling members 230 is small. Therefore, even when the second supports 220 are made of metal, it is easier to maintain the contact between the spring pins 310 and the conductive pads 102, and to restrict contact failures between the spring pins 310 and the conductive pads 102 due to temperature changes.

The quantum device 8 may have an interposer similar to the interposer 140.

The number of the second supports 220 provided with respect to one qubit chip 100 is not limited. For example, nine second supports 220 may constitute a matrix of three rows and three columns, and 16 second supports may constitute a matrix of four rows and four columns. The number in the row direction may be different from the number in the column direction. Further, the first support 210 may have a portion positioned between the wall plate of the container 410, the qubit chip 100, and the second supports 220.

The quantum device according to the present disclosure can be used for quantum computing, for example.

Although preferred embodiments and the like have been described in detail above, various modifications and substitutions may be made to the embodiments and the like without departing from the scope of the appended claims.

Although the modifications are numbered with, for example, "first," "second," or "third," the ordinal numbers do not imply priorities of the modifications. Many other variations and modifications will be apparent to those skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

### Explanation of Reference Numerals

1, 2, 3, 4, 5, 6, 7, 8: quantum devices
100: qubit chip
101: qubit
102: conductive pad
110: substrate
111: first main surface
112: second main surface
118, 148: recess
120: cover chip
140: interposer
150: conductive bonding member
170: qubit substrate
210: first support
212: metal layer
220: second support
222: protrusion
223: inclined surface
230: coupling member
250: spacer
310: spring pin
330: constraining member
340: rotation restricting member
341: first surface
342: second surface
400: housing
440: elastic pressing member

## Claims

1. A quantum device (1-8) comprising:
a qubit substrate (170) having qubits (101) and conductive pads (102) coupled to the qubits (101), the qubit substrate (170) having a first thermal expansion coefficient (α₁);
a first support (210) having a second thermal expansion coefficient (α₂);
a plurality of second supports (220) disposed between the qubit substrate (170) and the first support (210), each of the second supports (220) having a third thermal expansion coefficient (α₃);
a plurality of coupling members (230), each coupling the first support (210) and a corresponding second support of the second supports (220); and
spring pins (310) supported by the second supports (220) and in contact with the conductive pads (102),
wherein a control signal for controlling a state of each of the qubits (101) is supplied to a corresponding conductive pad of the conductive pads (102) through a corresponding spring pin of the spring pins (310), and
wherein an absolute value (Δα₂1) of a difference between the first thermal expansion coefficient (α₁) and the second thermal expansion coefficient (α₂) is smaller than an absolute value (Δα₃1) of a difference between the first thermal expansion coefficient (α₁) and the third thermal expansion coefficient (α₃).

2. The quantum device (1-8) according to claim 1, wherein the second supports (220) are metallic.

3. The quantum device (1-8) according to claim 1 or 2,
wherein the qubit substrate (170) has main surfaces (111, 112), and
wherein constraining members (330) are provided to restrain the qubit substrate (170) relative to the first support (210) in a direction parallel to the main surfaces (111, 112).

4. The quantum device (1-8) according to any one of claims 1 to 3, wherein each of the second supports (220) is coupled to the first support (210) by a plurality of coupling members (230).

5. The quantum device (1-8) according to any one of claims 1 to 4, further comprising:
a rotation restricting member (340),
wherein each of the second supports (220) has a protrusion (222) extending toward the qubit substrate (170), the protrusion (222) having an inclined surface (223) that inclines toward the qubit substrate (170) as the protrusion (222) extends away from the corresponding coupling member (230), the corresponding coupling member being from among the coupling members, and
wherein the rotation restricting member (340) has two first surfaces (341) in contact with the inclined surfaces (223) of two adjacent second supports (220), and a second surface (342) in contact with the qubit substrate (170), the two adjacent second supports being from among the second supports.

6. The quantum device (1-8) according to any one of claims 1 to 5, further comprising:
a housing (400) that accommodates the qubit substrate (170), the first support (210), the second supports (220), and the plurality of coupling members (230), the housing (400) having a fourth thermal expansion coefficient (α₄),
wherein an absolute value (Δα₂1) of a difference between the first thermal expansion coefficient (α₁) and the second thermal expansion coefficient (α₂) is smaller than an absolute value (Δα₄1) of a difference between the first thermal expansion coefficient (α₁) and the fourth thermal expansion coefficient (α₄).

7. The quantum device (1-8) according to claim 6, wherein the housing (400) is metallic.

8. The quantum device (1-8) according to claim 7, further comprising:
a metal layer (212) that covers the first support (210) and contacts the housing (400) and the second supports (220).

9. The quantum device (1-8) according to any one of claims 6 to 8, further comprising:
a spacer (250) disposed between the housing (400) and the first support (210).

10. The quantum device (1-8) according to any one of claims 1 to 9, wherein the qubit substrate (170) has a recess (118) into which a tip of the corresponding coupling member (230) is inserted, the corresponding coupling member being from among the coupling members (230).

11. The quantum device (1-8) according to any one of claims 1 to 10,
wherein the qubit substrate (170) includes a single-crystal silicon substrate, a sapphire substrate, a quartz substrate, or a diamond substrate, and
wherein the first support (210) includes a single-crystal silicon plate, a sapphire plate, a ceramic plate, a quartz plate, or a diamond plate.

12. The quantum device (1-8) according to any one of claims 1 to 11, wherein the qubit substrate (170) includes:
a qubit chip (100) having the qubits (101), and
an interposer (140) having the conductive pads (102), the interposer (140) being disposed between the qubit chip (100) and the second supports (220), fixed to the qubit chip (100), and electrically coupled to the qubit chip (100).

13. A quantum device (1-8) comprising:
a housing (400);
a qubit substrate (170) accommodated in the housing (400) and including qubits (101) and conductive pads (102) coupled to the qubits (101);
a plurality of supports (220) accommodated in the housing (400) and disposed between the qubit substrate (170) and the housing (400);
a spacer (250) accommodated in the housing (400) and disposed between the housing (400) and the plurality of supports (220);
a plurality of coupling members (230) accommodated in the housing (400), the plurality of coupling members (230) penetrating the spacer (250) and coupling the housing (400) and the plurality of supports (220); and
spring pins (310) supported by the plurality of supports and in contact with the conductive pads (102),
wherein the qubit substrate (170) includes a recess (118) into which a tip of a corresponding coupling member of the coupling members (230) is inserted, and
wherein a control signal for controlling a state of each of the qubits (101) is supplied to a corresponding conductive pad of the conductive pads (102) through a corresponding spring pin of the spring pins (310).
